Europäisches Patentamt

European Patent Office

Office européen des brevets

(19)

(11) **EP 0 692 718 A1**

(12) # EUROPEAN PATENT APPLICATION

(43) Date of publication:
17.01.1996 Bulletin 1996/03

(51) Int. Cl.⁶: **G01R 31/04**

(21) Application number: **94830346.6**

(22) Date of filing: **11.07.1994**

(84) Designated Contracting States:
AT BE CH DE DK ES FR GB GR IE IT LI LU MC NL PT SE

(71) Applicant: **SIX TAU S.p.A.**
I-10129 Torino (IT)

(72) Inventor: **Culasso, Giorgio**
I-10080 San Benigno Canavese (Torino) (IT)

(74) Representative: **Marchitelli, Mauro et al**
I-10152 Torino (IT)

(54) **A method and a device for testing an electric connector**

(57)     The method and the device are for testing an electric connector comprising a plurality of terminals (6) fixed to an insulating casing (4). For the test, a plurality of telescopic contacts (36) is provided, associated with an electrical circuit for detecting whether each contact is in the extended or the compressed condition. The spring contacts (36) are brought into contact with the terminals (6) of the connector (2) with predetermined kinetic energy so as to exert an impulsive mechanical stress on the terminals (6).

FIG. 1

EP 0 692 718 A1

## Description

The present invention relates to a method and a device for testing an electric connector comprising a plurality of terminals fixed to an insulating casing.

A device for testing that electrical terminals are fixed correctly to the respective seats of a cellular casing of an electric connector is known from the document DE-C-35 04 606. The device comprises a plurality of telescopic spring contacts which are urged against respective terminals of the connector. The spring contacts are associated with an electrical circuit which can detect whether each contact is in the extended or the compressed condition. Any faulty fixing of the terminals to the casing of the connector is indicated by an anomalous position of the respective spring contact.

In order to carry out the test, the connector is inserted and locked in a seat in the device. As soon as the contact is inserted in the seat, an electrical connection is established between the terminals of the connector and the respective spring contacts. The spring contacts are then urged further against the terminals, increasing the force of the contact between the terminals and the spring contacts. The terminals are subjected to a force which tends to expel them from the respective seats of the connector and the terminals which are fixed faultily move relative to the correct fixing position. The spring contacts are then moved partially away from the terminals so as to reduce the force of the contact which establishes the electrical connection with the terminals. The movement of the spring contacts away from the terminals should identify faultily-fixed terminals, since their spring contacts would be in more extended positions than if the terminal were fixed correctly.

For certain types of connectors, however, the system known from the document DE-C-35 04 606 does not reliably test the correct coupling of each terminal in its respective cell of the connector. In fact, one of the main problems to be overcome in order to test correct coupling is brought about by the need to overcome the static friction of the terminals which are fixed faultily or are not fixed at all. In particular, in the case of terminals with sealing rings, which have been introduced in recent years in the wiring harness market, the coupling test carried out by a device having the functional characteristics described above, which is based on the displacement of the spring contacts by a predetermined distance, does not, in certain cases, ensure effective detection of the coupling anomaly. In fact, a coupling test based on the displacement of the spring contact by a predetermined distance cannot ensure reliable detection since - even in the presence of a coupling anomaly - the friction of the sealing ring against the walls of the cell may restrain the terminal in the seat in the cell.

A further critical element of the test carried out according to the known method may be introduced by the presence of single-core wires with large cross-sections connected by clamping or taping to single-core wires of smaller cross-section inserted in the same casing. In fact, particularly if the wires are clamped or taped near the cells of the connector, a restraint system is produced which tends to cause the terminals to adhere to the walls of the cells, giving rise to a static friction component which has to be overcome.

In addition to the testing difficulties resulting from the presence of sealing rings and from the mutual connection of wires of different cross-sections, it is also necessary to take account of the fact that the connectors are composed of several individual components of various materials such as metal, rubber, thermoplastic materials etc. and temporary retention loads may arise in the terminals and may even be quite larger relative to the actual design value of the retention load of the terminals and to its value in use. Thus, if the terminal is acted on by a static force (even if it is greater than the nominal value), on a connector which has just been constructed, the connector may withstand this stress even with a faultily fixed terminal, whereas the same connector in use - when subject to stresses and vibrations - might yield, causing the electrical contact to fail.

The present invention has been developed as a result of the need to provide a testing device of a type similar to that described above which ensures a reliable test, overcoming the difficulties of the known device explained above.

The present invention performs this task by virtue of the characteristics which form the subject of the claims.

The invention will now be described, with reference to the appended drawings, provided purely by way of non-limiting example, in which:

Figure 1 is an exploded, perspective view of a device according to the present invention,
Figures 2 and 3 are sections taken on the lines II-II and III-III of Figure 1 in the rest condition,
Figures 4 and 5 are sections similar to those of Figure 2 and 3, showing the device during the testing of a connector,
Figure 6 is a diagram of a pneumatic circuit associated with the device according to the invention,
Figure 7 is a graph showing the curves of some parameters during the testing of a connector, and
Figure 8 is a graph similar to that of Figure 7, relating to a test method of the prior art.

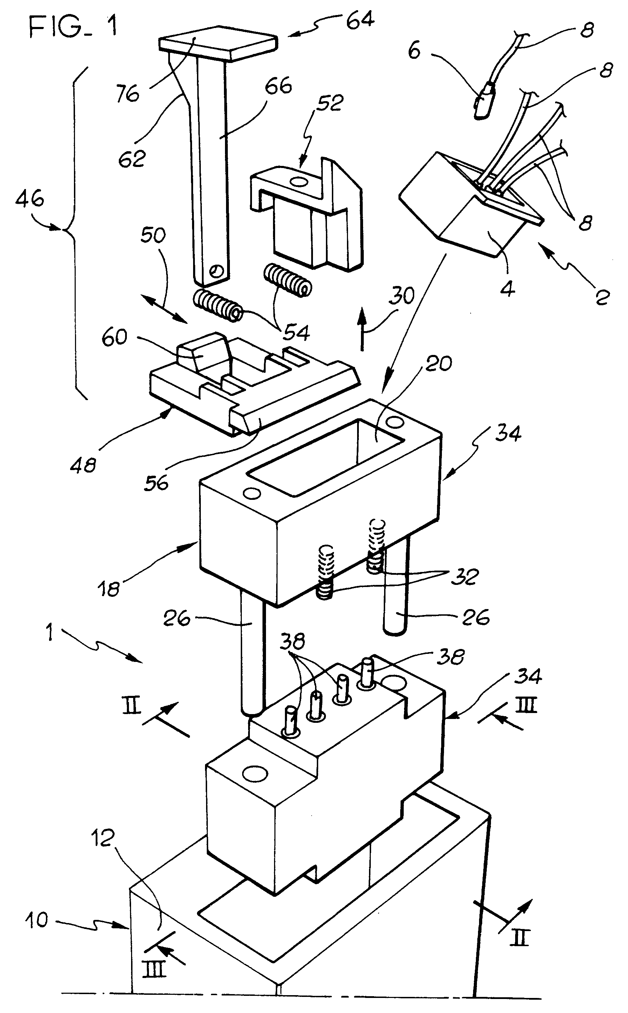

With reference to Figures 1-5, the reference 1 indicates a device for testing connectors 2 which are constituted by a cellular casing 4 of plastics material having a series of seats in which respective terminals 6, each connected to a wire 8, are fixed. The terminals 6 are fixed to the seats in conventional manner by means of mutually cooperating teeth.

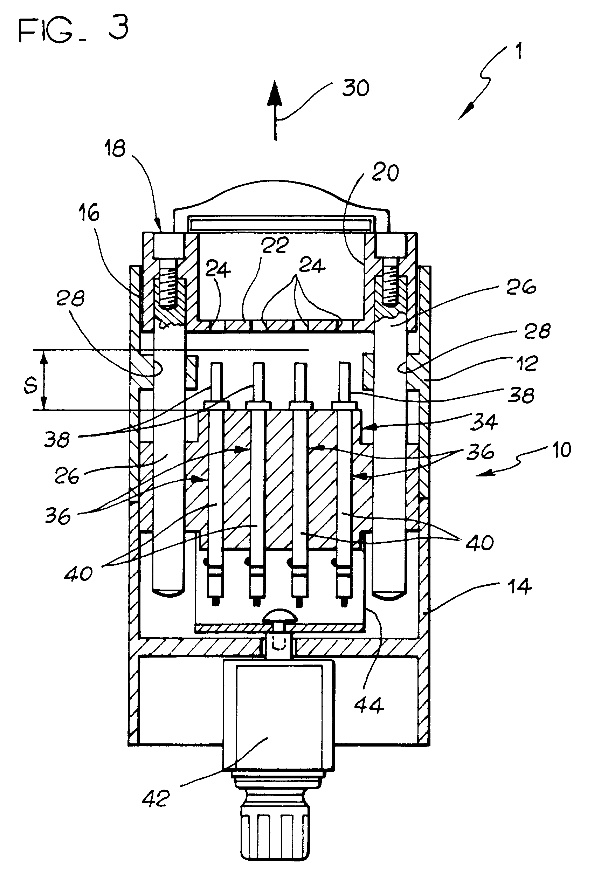

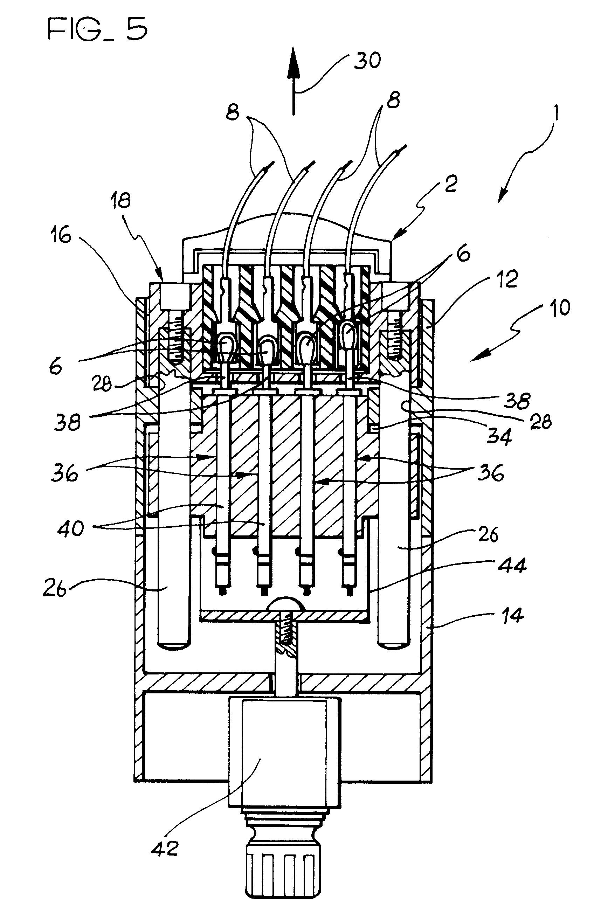

The device 1 comprises a base 10 of plastics material composed of two portions 12, 14 fixed together. The portion 12 of the base 10 has a cavity 16 in which a movable element 18 is slidable, a seat 20 being formed therein for housing the casing 4 of the connector 2. As can be seen in Figure 3 in particular, the seat 20 of the element 18 has a bottom wall 22 in which there is a plurality of holes 24 in positions corresponding to those of the terminals 6 of the connector 2 to be tested. The movable element 18 is fixed to two guide uprights 26 which engage slidingly in respective seats 28 (Figures 3 and 5) formed integrally in the portion 12 of the base 10. The movable element 18 is constantly urged in the direction indicated by the arrow 30, by a series of helical compression springs 32 interposed between the movable element 18 and the base 10.

A contact-holder body 34 of electrically insulating material is slidable on the guide uprights 26 and houses a plurality of telescopic spring contacts 36 each of which has a pin portion 38 which is movable telescopically relative to a tubular portion 40. The spring contacts 36 are normally available on the market and act as push-buttons for indicating, by the opening or closing of an electrical contact associated therewith, whether each spring contact is in an extended or compressed condition. The spring contacts used in the device according to the invention may be of the coaxial double-pin type, including a first pin 38 which projects telescopically from the tubular portion 40 and cooperates with a second spring pin constituting an electrical contact which indicates the projecting or retracted position of the telescopic pin 38. In rest conditions, the electrical contact associated with the pin 38 is in the open position, whilst if the pin 38 is urged inwardly of the tubular portion 40, the electrical contact is brought to a closed position.

The contact-holder body 34 is connected to a pneumatic actuator 42 by means of a flange 44. The actuator 42 moves the contact-holder body 34 between the rest position shown in Figure 3 and the operative position of Figure 5.

It is important to underline that, when the contact-holder body 34 is in the rest position, the ends of the pins 38 are spaced a certain distance from the base wall 22 of the seat 20 which houses the connector 2. The contact-holder body 34 can therefore perform an initial travel, the size of which is indicated S in Figure 3, before the pins 38 of the spring contacts 36 come into contact with the respective terminals 6 of the connector 2.

With reference to Figure 1, a locking device for restraining the connector 2 in the seat 20 of the movable element 18 is indicated 46. The locking device 46 comprises a locking member 48 which is movable relative to the base 10 in the directions indicated by the double arrow 50. The locking member 48 is connected to the base 10 by means of a guide body 52 (shown only partially in Figure 1) which is fixed relative to the base 10 and defines a sliding guide for the locking member 48. Two helical compression springs 54 interposed between the locking member 48 and the guide body 52 urge the member 48 towards a locking position.

The locking member 48 has a retaining portion 56 which is intended to bear on a surface 58 of the connector 2 to keep the latter in the seat 20. The locking member 48 has a wedge-shaped surface 60 which cooperates with a corresponding surface 62 of a release element 64.

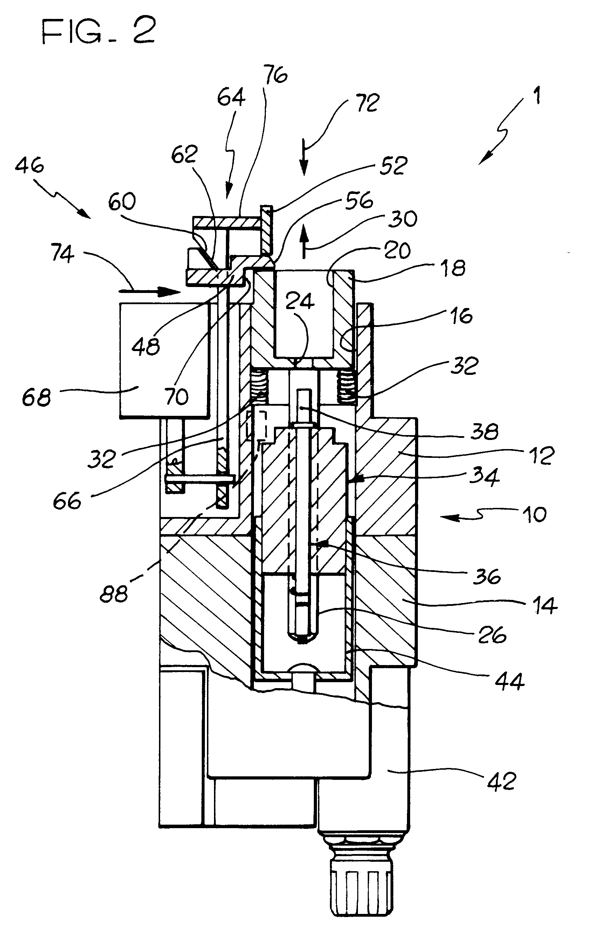

The release element 64 has an elongate portion 66 which is connected to a pneumatic release actuator 68 (Figure 2).

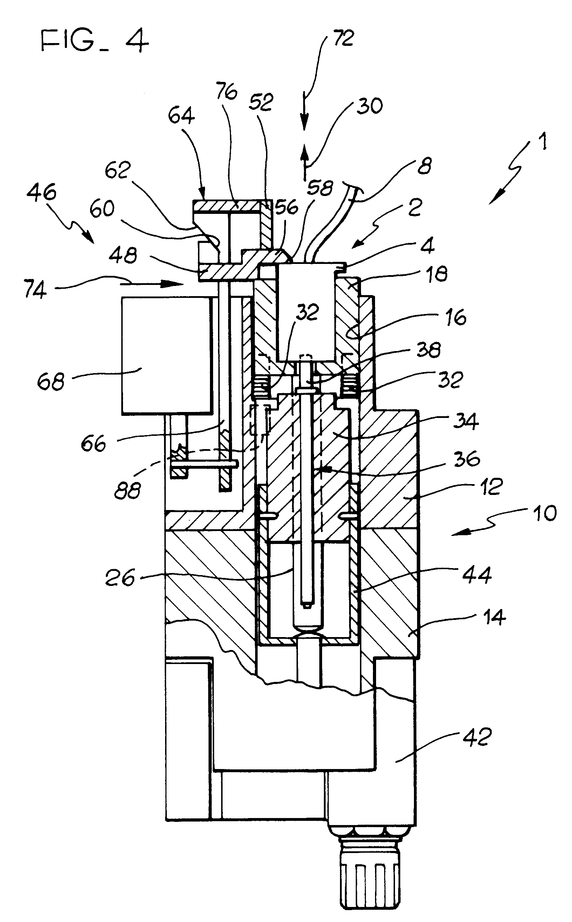

The operation of the locking device 46 will now be described with reference to Figures 2 and 4. In the configuration of Figure 2, the locking member 48 is retracted relative to the seat 20. The retaining portion 56 of the locking member 48 constitutes a restraint which prevents the movable body 18 from coming out under the action of the springs 32 which urge it in the direction indicated by the arrow 30. The springs 54 which urge the locking member 48 towards a locking position in which it is advanced relative to the seat 20 are compressed but the locking member 48 cannot move since a surface 70 thereof is in abutment with the movable body 18.

In order to lock a connector 2 in the seat 20, after the connector has been inserted in the seat, a force is exerted on the connector 2 in the direction indicated by the arrow 72 of Figures 2 and 4. This force causes the movable body 18 to move in the direction 72 against the action of the springs 32. As a result of the movement of the movable body 18, the locking member 48 is free to slide in the direction indicated by the arrow 74 in Figure 2 and thus moves to the locking position of Figure 4, in which the retaining portion 56 acts on the surface 58 of the connector 2.

Starting from the configuration of Figure 4, the connector 2 can be released automatically or manually. Automatic release is carried out by the supply of the actuator 68 which brings about a movement, in the direction 72, of the release element 64 which, as a result of the contact between the wedge-shaped surfaces 60, 62, causes the locking member 48 to be retracted. Manual release is effected by manual action on a head 76 of the release element 64 in the direction indicated by the arrow 72. The retraction of the locking member 48 releases the connector 2 and enables the movable body 18 to return to its projecting position under the action of the springs 32.

The device according to the invention may be used both for testing connectors which have already been assembled, and as a device for holding the connectors during the assembly stage. In the latter case, the cellular casing is inserted and locked in the seat 20 and the individual terminals 6 are then inserted and snap-engaged in the respective seats.

After the connector 2 has been locked as described above, the contact-holder body 34 is moved by the actuator 42 according to the sequence which will be described below, in order to test the connector 2.

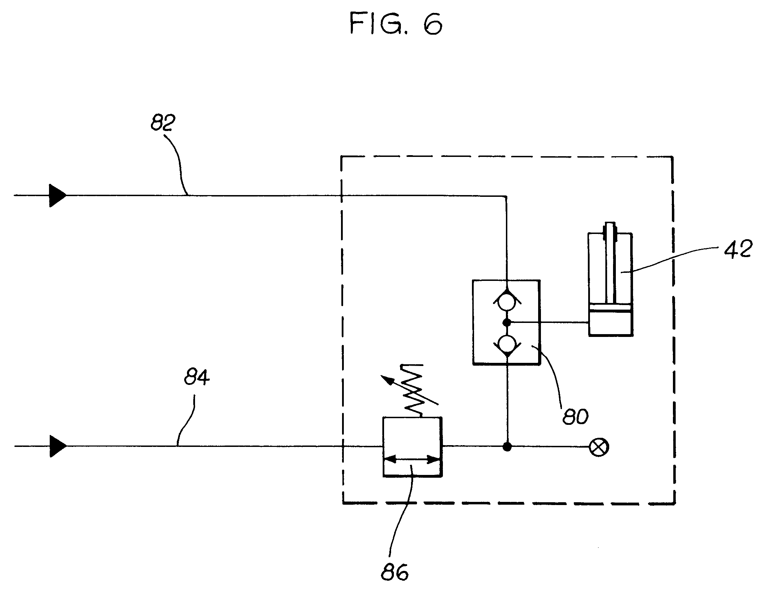

In order to carry out the test, the actuator 42 is supplied with two different pressure levels in succession. For this purpose, the actuator 42 is associated with a pneumatic circuit shown in Figure 6. With reference to this drawing, the actuator 42 is supplied by means of a pneumatic OR module 80 which is connected on one side to a relatively low-pressure supply line 82 and on the other side to a relatively high-pressure supply line 84 in which an electrically-controlled shut-off valve 86 is interposed.

The switching of the valve 86 between its operative positions enables the pneumatic actuator 42 to be supplied at a relatively high pressure level of about 6 bar or at a relatively low pressure level of about 3 bar.

The method of testing a connector is carried out in the following manner. After the connector 2 has been locked in the seat 20 of the movable element 18, a proximity switch, indicated 88 in Figures 2 and 4, detects the correct insertion of the connector 2 and provides consent for the test operations to start. In a first test step, the pneumatic actuator 42 is supplied at low pressure and brings the pins 38 of the spring contacts 36 into contact with the terminals 6 at a relatively low speed. In this first step, the electrical circuit associated with the spring contacts 36 carries out electromechanical functional tests to detect electromechanical or circuit anomalies. In this step, amongst other things, any errors in the positioning of the terminals 6 relative to the casing 4 of the connector emerge. If electromechanical or circuit anomalies are detected in this step, the subsequent procedure which involves the testing of the coupling of the terminals with the casing is not activated.

If no anomalies arise upon completion of the first test step, the contact-holder body 34 is returned to the rest position and the actuator 42 is then supplied at high pressure. Starting again from its rest position spaced from the terminals of the connector 2, the contact-holder body 34 is urged towards the connector 2 at a predetermined speed so as to bring the pins 38 of the spring contacts 36 into contact with the terminals 6 with a predetermined amount of kinetic energy. The spring contacts 36 act as energy dampers which act on the couplings between the individual terminals 6 and the casing 4 of the connector 2 with an impulse of a predetermined force such as to overcome any static friction and to cause the terminals 6 which are fixed in an anomalous manner in their cells of the casing 4 to move.

During the last test step, air is again supplied to the pneumatic actuator 42 at low pressure, returning the pins 38 of the spring contacts 36 into contact with the terminals 4. In this case, since the faultily-fixed terminals 6 have been urged into retracted positions in their cells in the preceding step, the spring contacts 36 will come to bear against all the terminals which remain in the correct positions in their cells, whilst a break in the electrical circuit will be identified for the terminals which are subjected to anomalous coupling. This test method can therefore distinguish whether the error detected by the electrical circuit results from an electromechanical anomaly (a wiring error, a break in the continuity of a wire, a short circuit between wires) or whether it results from an anomaly of the coupling of one or more terminals.

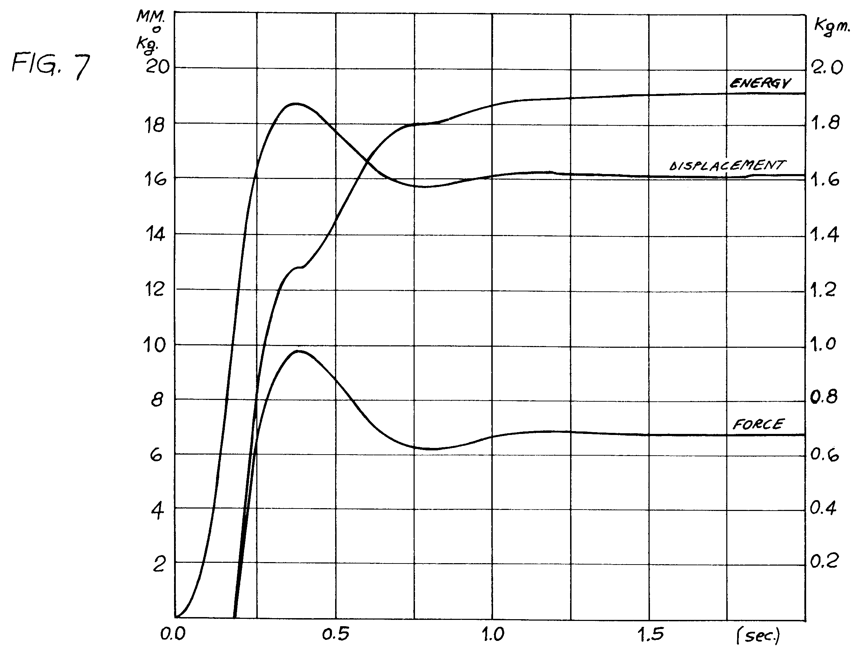

Figure 7 shows, by way of example, the curve of the impact energy as a function of time during the step for testing the mechanical fixing of the terminals 6. The curves of the contact force and of the displacement of the contact pins 38 are also shown in the same drawing. The graph of Figure 7 was obtained for a test device in which the movable mass of the contact-holder body 34 was 0.1 kg with a pneumatic actuator 42 having a bore of 12 mm, for a free travel of 10 mm at a pressure of 6 bar. Upon completion of its travel, the contact-holder body 34 will have reached an acceleration of 66.5 m/sec$^2$ and a speed of 3.64 m/sec. If the mass strikes the terminals 6 of the connector 2 with its own spring contacts 32 being of a size such as to stop the mass within a period of 10 msec, the contribution of the mass to the impact is the difference in momentum before and after the impact at the time of collision.

The impact will therefore produce a resultant force equal to the sum of the force of the pneumatic cylinder (6.78 kg) and the force restituted by the deceleration, that is

$$6.78 + 3.01 \text{ kg} = 9.8 \text{ kg},$$

but for a limited duration of 300 msec. The spring contacts 32 also bring about an oscillatory motion within the static equilibrium, generating an effect which cancels out any tensions in the couplings of the components of the connector.

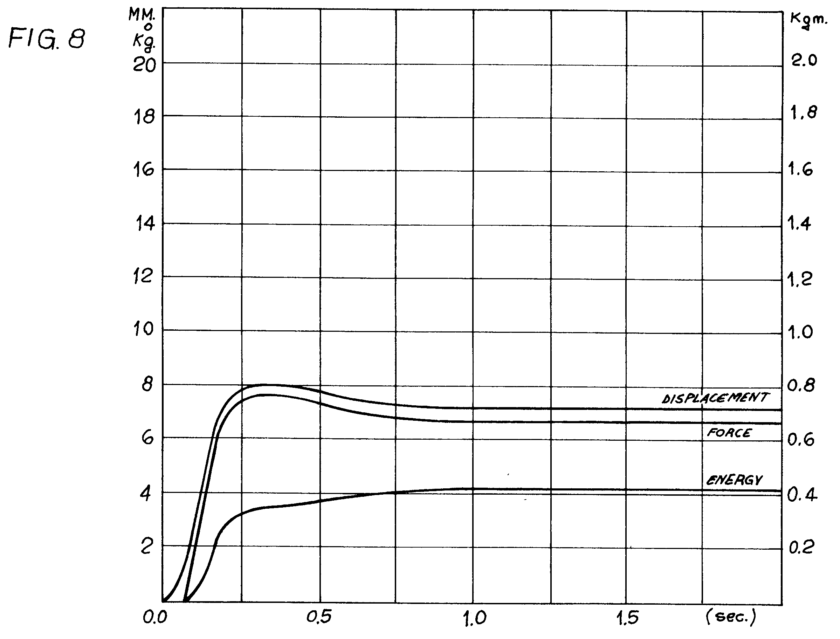

Figure 8 gives the time curve of the displacement, force and energy parameters for an identical test device activated by a test method according to the prior art, in which the terminals 6 are stressed only statically without the contact-holder body 34 effecting an initial travel before the pins 38 strike the terminals 6. In both cases, the comparison was carried out upon the assumption that the coupling test was carried out on a connector 2 having ten terminals 6, with the same:

- force of the individual spring contacts 32 at two thirds of the travel (1 kg),
- preloading force of the individual spring contacts 32 (0.2 kg),
- bore of the actuator cylinder of the spring contact-holder unit 34 (12 mm diameter),
- weight of the spring contact-holder unit 34 (0.1 kg),
- nominal pressure (6 bars).

In the device according to the invention, the contact-holder unit 34 was positioned with an initial travel of 10 mm, rather than near the connector 2.

From a comparison of Figures 7 and 8, it is clear that the kinetic energy applied to the coupling can reach four times greater values for a given force. Moreover, the device according to the invention enables the energy acting on the terminals 6 to be varied, for example, by varying the supply pressure of the actuator 42.

The graphic representations of the device shown in Figures 1-5 should be considered as examples, by way of indication, since many structural forms of the device of the invention may be devised.

**Claims**

1. A method of testing an electric connector (2) comprising a plurality of terminals (6) fixed to an insulating casing (4) in which there is a plurality of telescopic spring contacts (36) associated with an electrical circuit which can detect whether each contact (36) is in the extended or the compressed condition, and in which the contacts (36) are urged against respective terminals (6) and any faulty fixing of the terminals (6) is indicated by anomalous positions of the respective contacts (36), the method being characterized in that the contacts (36) are brought into contact with the terminals (6) of the connector (2) with predetermined kinetic energy so as to exert an impulsive mechanical stress on the terminals (6).

2. A method according to Claim 1, characterized in that, after the impulsive stress has been exerted on the terminals (6), the contacts (36) are brought close to the respective terminals (6) so as to establish an electrical connection solely with the terminals (6) which are fixed correctly.

3. A method according to Claim 1 or Claim 2, characterized in that, before the impulsive stress is exerted on the terminals (6), the contacts (36) are brought close to the respective terminals (6) so as to establish, between the terminals and the contacts, an electrical connection suitable for detecting any electromechanical or circuit error.

4. A device for testing an electric connector (2) comprising a plurality of terminals (6) fixed to an insulating casing (4), the device comprising:

- a support base (10) for housing a connector (2), with locking means (46) for restraining the connector (2) in the seat (20),
- a movable body (34) carrying a plurality of telescopic spring contacts (36) which, in use, are in positions corresponding to those of respective terminals (6) of the connector (2), the contacts (36) being associated with an electrical circuit for detecting the extended or compressed condition of the contacts (36),
- actuator means (42) for bringing about a movement of the movable body (34) between a rest position and an operative position,

characterized in that, in the rest position, the contacts (36) are spaced from the terminals (6) by a predetermined distance (S) so that the movable body (34) can reach a predetermined speed under the effect of the actuator means (42) before the spring contacts (36) contact the terminals (6).

5. A device according to Claim 4, characterized in that the actuator means comprise a pneumatic cylinder (42) supplied by means of a pressure-variating device (80, 86) defining a relatively high pressure level for urging the contacts (36) against the terminals (6) with a relatively high kinetic energy and a relatively low pressure level for urging the contacts (36) against the terminals (6) with a relatively low kinetic energy.

6. A device according to Claim 4, characterized in that the seat (20) for housing the connector (2) is formed in a movable body (18) fixed to a pair of guide uprights (26) which are slidable relative to the base (10) and on which the movable body (34) carrying the spring contacts (36) is slidable.

7. A device according to Claim 5, characterized in that it comprises a mechanism (46) for holding the connector (2) in the seat (20), the mechanism including a locking member (48) which is movable perpendicular to the directions in which the connector (2) is inserted and removed.

8. A device according to Claim 7, characterized in that the locking member (48) is associated with a release member (64) which can be operated either manually or by means of a release actuator (68).

FIG. 1

EP 0 692 718 A1

6

FIG. 2

FIG. 3

FIG. 4

FIG_ 5

FIG. 6

FIG. 7

FIG. 8

EP 0 692 718 A1

European Patent
Office

**EUROPEAN SEARCH REPORT**

Application Number

EP 94 83 0346

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A,D | GB-A-2 170 962 (KAHL)<br>* abstract *<br>* page 1, line 103 - line 116; figure 1 *<br>--- | 1,4 | G01R31/04 |
| A | FR-A-2 690 250 (HERNANDEZ)<br>--- | | |
| A | FR-A-2 585 136 (RENAULT)<br>----- | | |

TECHNICAL FIELDS
SEARCHED        (Int.Cl.6)

G01R
G01M

The present search report has been drawn up for all claims

| Place of search | Date of completion of the search | Examiner |
|---|---|---|
| THE HAGUE | 6 December  1994 | IWANSSON, K |

EPO FORM 1503 03.82 (P04C01)